# EUROPÄISCHE PATENTSCHRIFT

(11) **EP 2 756 526 B1**
(45) Veröffentlichungstag und Bekanntmachung des Hinweises auf die Patenterteilung: **30.09.2015**
(21) Anmeldenummer: 12753943.5
(22) Anmeldetag: 28.08.2012
(51) Int. Cl.: H01L 31/048

(54) **POLYMERE MATERIALIEN FÜR AUSSENANWENDUNGEN MIT SELBSTHEILENDEN OBERFLÄCHENEIGENSCHAFTEN NACH VERKRATZEN ODER ABRASIONSBESCHÄDIGUNG**
POLYMERIC MATERIALS FOR EXTERNAL APPLICATIONS WITH SELF-HEALING SURFACE PROPERTIES AFTER SCRATCHES OR ABRASION DAMAGE
MATIÈRES POLYMÈRES POUR UTILISATIONS EXTÉRIEURES PRÉSENTANT DES PROPRIÉTÉS DE SURFACE AUTORÉGÉNÉRATRICES APRÈS LA FORMATION D'ÉRAFLURES OU UN ENDOMMAGEMENT PAR ABRASION

(30) Priorität: 14.09.2011 DE 102011113160
(43) Veröffentlichungstag der Anmeldung: 23.07.2014
(73) Patentinhaber: Evonik Röhm GmbH, 64293 Darmstadt (DE)
(72) Erfinder: NUMRICH, Uwe, 64846 Groß-Zimmern (DE); KANZLER, Waldemar, 74321 Bietigheim-Bissingen (DE); SZALLIES, Maren, 63538 Großkrotzenburg (DE); ACKERMANN, Jochen, 64367 Mühltal (DE); OLBRICH, Michael, 63791 Karlstein (DE)
(86) Internationale Anmeldenummer: PCT/EP2012/066643
(87) Internationale Veröffentlichungsnummer: WO 2013/037632

(56) Entgegenhaltungen:
- WO-A1-2011/007700
- US-A1- 2010 319 753
- US-A1- 2010 326 501
- US-A1- 2011 168 262
- US-A1- 2011 168 436

## Beschreibung

### Gebiet der Erfindung

Die Erfindung betrifft Oberflächenveredlungen für Verbundformkörper aus polymeren Materialien und deren Anwendung in Solaranlagen. Bei diesen Solaranlagen kann es sich um Solarreflektoren zur Konzentration Solarer Strahlung, um flexible Photovoltaikverbundfolien oder um CPV-Linsen (Concentrated Photovoltaics-Linsen) zur Konzentration solarer Strahlung handeln.

Bei der Oberflächenveredelung handelt es sich um eine selbstheilende Beschichtung auf Basis von vernetzbaren Fluorpolymeren, z.B. PFEVE (Polyfluorethylenalkylvinylether). Diese Beschichtungen zeigen gute optische Eigenschaften, sind in Außenanwendungen, insbesondere in Solaranwendungen, über sehr lange Zeiträume einsetzbar, zeigen selbstreinigende Eigenschaften und vor allem ist die Beschichtung in Bezug auf mechanische Beschädigungen - wie Verkratzen - selbstheilend.

### Stand der Technik

Polymere Verbundformkörper in Solarreflektoren nach dem Stand der Technik weisen Nachteile in Bezug auf eine ausreichende Langlebigkeit auf. Insbesondere bei Außenanwendungen über einen Zeitraum von 20 Jahren oder mehr, sind sowohl etablierte Glasspiegel als auch im Besonderen Verbundformkörper auf Basis von Polymerschichten anfällig für oberflächige Beschädigungen wie Verkratzen. Ursachen dafür können zum Beispiel von Wind aufgewirbelter Sand oder das Reinigen mit Bürsten sein.

Gelöst werden kann dieses Problem durch Beschichtung mit Polysiloxanen, wie CRYSTALCOAT™ MP-100 der Firma SDC Techologies Inc., AS 400 - SHP 401 oder UVHC3000K, beide von der Firma Momentive Performance Materials. In einer Langzeitanwendung über einen Zeitraum von mindestens 20 Jahren in einem Außenbereich, wie sie insbesondere für Solarreflektoren oder Photovoltaikzellen benötigt wird, zeigen solche Materialien jedoch keine ausreichende Abriebfestigkeit.

In US 5,118,540 werden zur Verbesserung des Oberflächenschutzes abriebsfeste und feuchtigkeitsbeständige Folie auf Basis von Fluorkohlenstoff-Polymeren, wie PVDF, aufgeklebt. Sowohl das UV-Absorptionsreagenz als auch der Korrosions-Inhibitor sind Bestandteil der Klebschicht, mit der die Folie mit der Metalloberfläche der bedampften Polyesterträgerfolie verbunden ist. Dabei kann die Klebschicht wiederum analog zu der oben ausgeführten (Meth)acrylat Doppelbeschichtung aus zwei verschiedenen Schichten bestehen, um Korrosions-Inhibitor und UV-Absorptionsreagenz voneinander zu trennen. Eine solche Beschichtung zeigt jedoch keine ausreichende Langzeitbeständigkeit gegenüber Verkratzen.

Eine weitere Lösung des Standes der Technik sind anorganische Kratzfestbeschichtungen. In EP 1 629 053 wird eine solche Beschichtung aus Siliziumdioxid- oder Aluminiumoxidteilchen mit Durchmessern kleiner 1 µm zur Beschichtung von Folienlaminaten, die als wetterfeste Folien Verwendung finden, offenbart. Solche anorganischen Beschichtungen haben jedoch den Nachteil, dass sie unter den in Solarkraftwerken üblichen Bedingungen nur relativ kurz, d.h. maximal wenige Jahre, haltbar sind. Durch Sandverwehungen bzw. gar Sandstürme oder andere klimatische Bedingungen in sehr heißer und vor allem trockener Umgebung kommt es zum Abrieb solcher Beschichtungen.

In WO 2010/078105 sind Solarreflektoren mit einer Kratzfestbeschichtung auf polymerer Basis, die zusätzlich mit einer Antisoiling-Beschichtung aus Fluorpolymeren oder Polysiliconen kombinierbar ist, beschrieben. Als Beschichtungsmittel zur Verbesserung der Kratzfestigkeit werden thermoplastische Polyurethane (z.B. TECOFLEX^{®} der Firma Lubrizol) oder vernetzbare Polysiloxane (z.B. PERMA-NEW 6000 der Firma California Hardcoating Co.) aufgeführt. Bei beiden Beschichtungen handelt es sich um so genannte Hardcoatings. Auch solche Systeme zeigen bei längerer, intensiver Beanspruchung, wie sie weiter oben beschrieben in Wüsten oder Steppen auftreten, eine Verkratzung oder einen Abrieb. Darüber hinaus haben Polysiloxane keine optimale UV-Stabilität unter derartig intensiver Langzeiteinwirkung.

Das Dokument US2011/168436A beschreibt Materialien für Soloranlagen.

### Aufgabe

Es bestand die Aufgabe, eine neuartige Oberflächenveredelung für Solaranlagen, insbesondere für Solarreflektoren, flexible Photovoltaiksysteme oder CPV-Linsen, zur Verfügung zu stellen. Mit dieser Oberflächenveredelung soll bei Außenanwendungen über einen Zeitraum von mehr als 15 Jahren einer Verkratzung und der damit verbundenen Effizienzminderung entgegengewirkt werden.

Weiterhin bestand die Aufgabe, dass Solaranlagen, mit dieser Oberflächenveredelung ausgestattet, gegenüber dem Stand der Technik zumindest gleichwertige optische Eigenschaften und Witterungsbeständigkeit aufweisen.

Des Weiteren bestand die Aufgabe, dass der Verbundformkörper für Solarreflektoren unter besonders starker Sonnenbestrahlung, wie sie z.B. in der Sahara oder im Südwesten der USA vorkommt, für lange Zeit stabil bleibt.
Dies gilt insbesondere betreffend der Eigenbeständigkeit und Filtereffizienz der Oberflächenvergütungsschicht dieser Verbundformkörper gegenüber dem UV-Wellenlängenspektrum zwischen 295 und 380 nm.

Es bestand darüber hinaus die Aufgabe, Oberflächenveredelungen für Solaranlagen zur Verfügung zu stellen, die einfach und kosteneffizient herzustellen und aufzubringen sind.

### Lösung

Vor dem Hintergrund des Standes der Technik und den dort beschriebenen für Langzeitanwendungen nur mangelhaften technischen Lösungen, gelingt es in der vorliegenden Erfindung auf eine für den Fachmann nicht ohne weiteres absehbare Weise, einen Verbundformkörper mit über einen langen Zeitraum verbesserter Oberflächenqualität bereitzustellen. Dies erfolgt durch Bereitstellen eines Verbundformkörpers nach Anspruch 1.

Unter dem Begriff "selbstheilende Eigenschaft" wird im Rahmen dieser Erfindung die Eigenschaft einer Kunststoffschicht, unter Einwirkung von insbesondere Wärme oder elektromagnetischer Strahlung, wie UV-Strahlung, eine Veränderung der Oberfläche des Materials derart zu bewirken, dass Kratzer oder kleine Risse wieder geschlossen werden, ohne dass bei gleicher Einwirkung dabei die Grundform der Schicht - z.B. in Bezug auf deren optische Eigenschaften, die Schichtdicke und deren Verteilung über die Schicht - verändert wird, verstanden. Solche selbstheilende Schichten umfassen z.B. Systeme, die physikalisch, z.B. durch starke van-der-Waals-Wechselwirkungen, Wasserstoffbrücken oder durch Ionenverknüpfungen vernetzt sind. Diese Vernetzungsstellen können teilweise durch Energiezufuhr gelöst und später wieder verknüpft werden. In dieser Variante kann die Energiezufuhr durch Wärme oder elektromagnetische Strahlung erfolgen.

In einer besonders geeigneten, überraschend gefundenen Variante weist das selbstheilende Material der äußeren Schicht eine Glastemperatur zwischen 10 und 70 °C, bevorzugt zwischen 20 und 60 °C auf. Dabei ist das Material bevorzugt irreversibel vernetzt.

Der Vernetzungsgrad wird bevorzugt demgemäß gestaltet, dass die einzelnen Kettensegmente zum einen oberhalb der Glasübergangstemperatur des Materials eine gewisse Bewegungsfähigkeit aufweisen, sowie - zum anderen - eine ausreichende Härte und Abriebfestigkeit der Beschichtung resultiert.

Besonders bevorzugt sind dabei vernetzbare Fluorpolymere, die als Lösungspolymerisat oder als wässrige Dispersion eingesetzt werden können. Beispiele für vernetzbare Fluorpolymere sind Block-Terpolymere aus Vinylidendifluorid, Tetrafluorethylen und einem Vinylester, wie z.B. Vinylbutyrat oder Copolymere aus Tetrafluorethylen und Hydroxyalkylvinylethern. Letzteres kann z.B. mit Hexa(methoxymethyl)melamin ausgehärtet werden. Keines dieser Polymere war bis dato derart bekannt, dass die Beschichtungen selbstheilende Eigenschaften aufweisen würden.

Ein Beispiel für Poly(fluorethylen-alkylvinylether) (PFEVE) wird beispielsweise unter dem Namen Lumiflon® von der Firma Asahi Glass Chemicals vertrieben.

Im Allgemeinen versteht man unter PFEVE Copolymere aus Trifluorethylen, Tetrafluorethylen oder Trifluorchlorethylen einerseits und einem Vinylether andererseits. Dabei sind die Fluorethylen- und die Vinyletherbausteine in der Regel alternierend in der Kette eingebaut. Die copolymerisierten Vinylether stellen in der Regel eine Mischung verschiedener Verbindungen dar, wobei ein Teil davon eine zusätzliche Funktionalität aufweisen kann. Bei diesen Funktionalitäten kann es sich neben polaren Gruppen, die zur besseren Dispergierung von Pigmenten, wie z.B. Säuregruppen, geeignet wären, vor allem um vernetzbare Gruppen, wie Doppelbindungen, Hydroxy- oder Epoxygruppen, handeln.

Besonders überraschend wurde im Rahmen dieser Erfindung gefunden, dass PFEVE basierende Beschichtungen selbstheilende Eigenschaften, insbesondere unter den für Solaranwendungen charakteristischen Bedingungen, aufweisen.

Da PFEVE darüber hinaus vollständig amorph ist, haben die korrespondierenden Formulierungen und Beschichtungen gute optische Eigenschaften und eine hohe Transparenz. Weiterhin besitzt PFEVE eine sehr gute Witterungsbeständigkeit über eine sehr lange Zeitspanne, auch unter extremen Bedingungen. So sind PFEVE basierende Beschichtungen äußerst UV-beständig und haben zudem sehr gute Barriereeigenschaften gegenüber Luftsauerstoff und Wasser, z.B. in Form von Luftfeuchtigkeit.

Die äußere, selbstheilende Schicht weist eine Dicke zwischen 0,5 µm und 200 µm, bevorzugt zwischen 2 µm und 150 µm und besonders bevorzugt zwischen 5 µm und 50 µm auf.

Der erfindungsgemäße, neuartige, eine selbstheilende Schicht aufweisende Verbundformkörper für Anlagen zur solaren Energiegewinnung weist folgende Eigenschaften, in Kombination als Vorteil gegenüber dem Stand der Technik, besonders in Hinblick auf optische Eigenschaften, auf:

Der transparente Anteil des erfindungsgemäßen Verbundformkörpers ist besonders farbneutral und trübt sich bei Feuchtigkeitseinfluß nicht ein. Der Verbundformkörper zeigt zudem eine ausgezeichnete Witterungsbeständigkeit und, bei Ausstattung mit der beschriebenen, auf Fluorpolymeren basierenden, Oberfläche, eine sehr gute Chemikalienbeständigkeit, beispielsweise gegen sämtliche handelsübliche Reinigungsmittel. Auch diese Aspekte tragen zum Erhalt der solaren Reflektion über einen langen Zeitraum bei.

Das erfindungsgemäße Material kann auch über einen sehr langen Zeitraum von mindestens 15 Jahren, bevorzugt sogar mindestens 20 Jahren, besonders bevorzugt mindestens 25 Jahren an Orten mit besonders vielen Sonnenstunden und besonders intensiver Sonnenstrahlung, wie z.B. im Südwesten der USA oder der Sahara in Sonnenreflektoren eingesetzt werden. Insbesondere unter diesen klimatischen Bedingungen führen die selbstheilenden Schichten zu einer besonders lange verbleibenden guten Oberflächenqualität und damit zu einem - über einen langen Anwendungszeitraum - hohen Wirkungsgrad der Anlage zur solaren Energiegewinnung.

Dabei haben die erfindungsgemäßen Verbundformkörper vor allem unter mechanischer Belastung der Oberfläche selbstheilende Eigenschaften. Dies verlängert die Lebensdauer der solaren Anlagen auch in Regionen mit regelmäßigen Sandstürmen bzw. stark staubhaltigen Winden oder bei regelmäßiger Bürstenreinigung der Oberfläche.

Weiterhin ist die erfinderisch eingesetzte Oberflächenveredelung in Form einer selbstheilenden Schicht unabhängig von der Geometrie und technischen Auslegung der Anlage zur solaren Energiegewinnung applizierbar. Bei den Anlagen kann es sich beispielsweise um flexible Folien, biegbare Bleche oder sogar um mehrere cm dicke Platten handeln.

Darüber hinaus ist der erfindungsgemäße Verbundformkörper besonders feuchtigkeitsstabil, insbesondere gegenüber Regenwasser, Luftfeuchtigkeit oder Tau. Somit zeigt dieser nicht die bekannte Anfälligkeit für Delamination einer reflektierenden Beschichtung von den Trägerschichten Unter Feuchtigkeitseinfluss. PFEVE-basierende Beschichtungen besitzen eine besonders gute Barrierewirkung gegenüber Wasser.

Darüber hinaus weisen PFEVE basierende Beschichtungen eine besonders gute Barrierewirkung gegenüber Sauerstoff auf. Damit haben derartige Beschichtungen in einem erfindungsgemäßen Verbundformkörper des Weiteren den Vorteil, dass die Silberschicht in einem Solarreflektor bzw. die Halbleiterschicht in einer Photovoltaikzelle gegenüber Oxidation geschützt sind.

Weiterhin weisen insbesondere PFEVE basierende Beschichtungen neben den selbstheilenden Eigenschaften an sich schon eine sehr gute Kratz- und Abriebfestigkeit auf, so dass dieser Effekt zusätzlich zur Langlebigkeit der besonders bevorzugten erfindungsgemäßen Verbundformkörper beiträgt.

### Detaillierte Beschreibung

### Verfahren zur Herstellung der erfindungsgemäßen Verbundformkörper

Neben den bereits beschriebenen Verbundformkörpem für Solaranlagen ist auch deren Herstellung über ein neues Verfahren Teil der vorliegenden Erfindung. In diesem Verfahren wird ein noch unbeschichteter Verbundkörper, mindestens eine Schicht aufweisend, die zu mehr als 50 Gew% aus PMMA oder einer PMMA-haltigen Polymermischung besteht, mit einer PFEVE basierenden Formulierung in einer Dicke zwischen 0,5 µm und 200 µm, bevorzugt zwischen 2 µm und 150 µm und besonders bevorzugt zwischen 5 µm und 50 µm beschichtet.

Insbesondere wird ein Verfahren verwendet, in dem das PFEVE in organischer Lösung gemeinsam mit weiteren Formulierungsbestandteilen als "Organosol" auf den Verbundformkörper aufgetragen und die aufgetragene Schicht anschließend getrocknet wird. Dabei erfolgt die Beschichtung beispielsweise mittels Knife Coating, Roll Coating, Dip Coating, Curtain Coating, Spray Coating. Während des Trocknens erfolgt parallel die Vernetzung der PFEVE basierenden Schicht.

Bevorzugt weist das PFEVE OH-Gruppen auf und wird mit einem Polyisocyanat, wie z.B. HDI oder Polyisocyanaten auf Basis von HDI, vernetzt.

Ein Beispiel für einen geeigneten solchen Vernetzer ist Desmodur^{®} BL 3175 der Firma Bayer. Zur Beschleunigung der Vernetzung können zusätzlich geeignete Vernetzungskatalysatoren, wie z.B. Dibutyl-zinn-dilaureat (DBTDL) zugesetzt werden. In einem solchen System wird die Vernetzermenge dergestalt eingestellt, dass das Verhältnis zwischen OH-Gruppen und NCO-Gruppen zwischen 0,5 bis 1,5, bevorzugt zwischen 0,8 und 1,2 und besonders bevorzugt zwischen 0,9 und 1,1 liegt. Im Falle von OH-funktionellen Polymeren weisen diese bevorzugt eine OH-Zahl zwischen 20 und 120 mg KOH/g, und besonders bevorzugt zwischen 30 und 110 mg KOH/g auf.
Diese Verhältnisse zwischen den beiden für die Vernetzungsreaktion nötigen funktionellen Gruppen und der Anteil funktioneller Gruppen im verwendeten Polymer sind auch auf andere Systeme, mit anderen Vernetzungsmechanismen übertragbar.

Diese beispielhaften Zahlen beziehen sich vor allem auf Systeme aus HDI-Kondensaten und DBTDL. Bei anderen Systemen, deren Komponenten in Bezug auf die jeweiligen Molekulargewichte oder Zahl der Funktionalitäten deutlicher abweichen, sind die angegebenen Grenzbereiche entsprechend anzupassen.

Dieser Verfahrensschritt der Beschichtung kann in einer Beschichtungsanlage auf einem vorgefertigten unbeschichteten Verbundformkörper erfolgen. Bevorzugt kann die Beschichtung aber auch in-line, direkt nach der Herstellung des Verbundformkörpers durchgeführt werden. Die Verbundformkörper werden - in der Ausführungsform als Mehrschichtfolie - mittels Laminierung hergestellt. In einem solchen Fall ist die oben beschriebene Beschichtungsanlage in-line hinter der Laminationsanlage aufgestellt und es erfolgt die Beschichtung des frisch hergestellten Verbundformkörpers.

Wie bereits weiter oben beschrieben kann die PFEVE basierende Schicht anschließend optional mit einer oder mehreren weiteren funktionellen Schichten versehen werden.

### Optionale Zuschlagsstoffe in der selbstheilenden Schicht

Die selbstheilende Schicht, bevorzugt auf Basis einem vernetzbaren Fluorpolymer und besonders bevorzugt auf Basis von PFEVE, kann weitere Zuschlagsstoffe enthalten. Dabei kann es sich zum einen um UV-Stabilisatoren und/oder UV-Absorber, wie insbesondere HALS-Verbindungen (stark sterisch gehinderte Amine) sowie Triazin-basierende UV-Absorber handeln. Zum anderen können insbesondere auch anorganische Nanopartikel, vor allem aus Siliziumoxiden, zur zusätzlichen Verbesserung der Kratz- und Abriebfestigkeit eingemischt werden. Dabei können bis zu 40 Gew%, bevorzugt bis zu 30 Gew% dieser Nanopartikel enthalten sein. Entscheidend ist dabei, dass diese Nanopartikel keine lichtbrechenden Eigenschaften haben und die Polymermatrix nicht getrübt wird.

### Weitere (anorganische) Schichten

Die erfindungsgemäßen Verbundformkörper können optional auf der äußeren PFEVE basierenden Schicht zusätzlich eine sehr dünne anorganische Beschichtung zur weiteren Verbesserung der Oberflächeneigenschaften aufweisen. Bei diesen zusätzlichen Beschichtungen kann es sich beispielsweise um eine zusätzliche Kratzfestbeschichtung, um eine leitfähige Schicht, um eine Antisoiling-Beschichtung und/oder um eine reflektionserhöhende Schicht bzw. um andere optisch funktionelle Schichten handeln. Diese zusätzlichen Schichten können beispielsweise mittels Physical Vapour Deposition (PVD) oder Chemical Vapour Deposition (CVD) aufgebracht werden.

Eine zusätzliche Kratzfestbeschichtung kann optional zur weiteren Verbesserung der Kratzfestigkeit aufgetragen werden. Dies ist bei der guten Qualität der erfindungsgemäßen Verbundformkörper in der Regel jedoch nicht nötig. Bei Kratzfestbeschichtungen kann es sich z.B. um Siliziumoxid-Schichten handeln, die direkt mittels PVD oder CVD aufgetragen werden.

Bei den optionalen leitfähigen Schichten handelt es sich um metalloxidsche Schichten, z.B. aus Indium-Zinn-oxid (in der Regel mit der Abkürzung ITO bezeichnet). Diese haben den Zweck, elektrostatische Aufladungen zu verhindern. Dies hat sowohl beim Betrieb der Solaranlagen, z.B. in Bezug auf ein Verstauben, als auch bei der Verarbeitung der Verbundformkörper große Vorteile. Neben ITO können auch beispielsweise antimon- oder fluordotiertes Zinnoxid sowie aluminiumdotiertes Zinkoxid verwendet werden.

Die Oberfläche der Verbundformkörper kann darüber hinaus, um die Reinigung zu erleichtern, mit einer schmutzabweisenden bzw. schmutzzerstörenden Beschichtung, einer so genannten Antisoiling-Beschichtung, ausgestattet sein. Auch diese Beschichtung kann mittels PVD oder CVD appliziert werden.

Die Applikation von Titandioxid bewirkt, nach entsprechender Anregung durch den UV-Anteil der solaren Strahlung, einen katalytischen Abbau oberflächlicher Sporen und Algen.

Bei den optisch funktionellen Schichten wiederum handelt es sich bevorzugt um reflektionserhöhende dielektrische Schichten, die in Solarreflektoren Anwendung finden können. Diese sind z.B. aus Siliziumdioxid- und Titandioxid-Wechselschichten aufgebaut. Es können aber auch Magnesiumfluorid, Aluminiumoxid, Zirkoniumoxid, Zinksulfid oder Praseodym-Titan-oxid verwendet werden. Diese Schichten können je nach Aufbau auch gleichzeitig als Kratzfestbeschichtung und/oder UV-reflektierend wirken.
In einer weiteren möglichen Variante der vorliegenden Erfindung befindet sich auf der selbstheilenden Schicht eine weitere, vergleichsweise dünne, extrem abriebfeste Schicht. Hierbei handelt es sich um eine besonders harte duroplastische Schicht mit einer Dicke unter bevorzugt 5 µm, besonders bevorzugt zwischen 0,5 und 2,0 µm. Beispielsweise kann diese Schicht aus einer Polysilazan-Formulierung hergestellt werden.
Eine solche Ausführungsform mit einer unteren thermoplastischen Trägerschicht, einer dünneren, mittleren, vernetzten Schicht, in Form der selbstheilenden Schicht und einer sehr dünnen äußeren extrem harten duroplastischen Schicht nennt man auch Gradient-Coating. Solche Systeme bringen eine zusätzliche Kratzfestigkeit und Oberflächenstabilität mit sich.

### Detaillierte Beschreibung der Verwendung

Die erfindungsgemäßen Verbundformkörper können insbesondere in drei verschiedenen bevorzugten Ausführungsformen Anwendung finden.

In der ersten bevorzugten Ausführungsform handelt es sich bei dem Verbundformkörper um einen Solarreflektor für Solarthermieanlagen.

Insbesondere weist ein solcher Verbundformkörper in dieser ersten bevorzugten Ausführungsform von der der Sonne zugewandten Seite aus mindestens folgende Schichten auf:
eine selbstheilende Schicht,
eine erste Trägerschicht,
eine optionale zweite Trägerschicht,
eine reflektierende Beschichtung aus Silber, einer Silberlegierung oder Aluminium auf der Rückseite der zweiten Trägerschicht und
optionale weitere mittels PVD oder CVD aufgetragene Beschichtungen, die sich auf der Oberseite, der Rückseite des Verbundformkörpers oder auf. der Oberseite der reflektierenden Beschichtung befinden können.

Solche Solarreflektoren ohne selbstheilende, insbesondere ohne PFEVE basierende Beschichtung finden sich beispielsweise in WO 2011/012342 oder in WO 2011/045121.

Eine besonders bevorzugte Variante findet sich in der deutschen Patentanmeldung mit der Anmeldenummer 102011077878.0. Dieser Verbundformkörper weist - um die erfindungsgemäße Beschichtung in Form einer PFEVE-Schicht ergänzt - von der der Sonne zugewandten Seite aus mindestens folgende Schichten auf:
eine PFEVE basierende Schicht,
eine erste Trägerschicht, die zu mehr als 50 Gew% aus PMMA oder einer PMMA-haltigen Polymermischung besteht, und eine Dicke zwischen 6 µm und 10 cm aufweist,
eine zweite Trägerschicht aus Polycarbonat oder einem Polyester, die eine Dicke zwischen 0,5 µm und 2 cm aufweist,
eine reflektierende Beschichtung aus Silber, einer Silberlegierung oder Aluminium auf der Rückseite der zweiten Trägerschicht, welche mittels PVD oder CVD aufgetragen wurde und
optionale weitere mittels PVD oder CVD aufgetragene Beschichtungen.

In einer zweiten, gleichsam bevorzugten Ausführungsform handelt es sich bei dem Verbundformkörper um eine Barrierefolie für Photovoltaikanlagen. Solche Barrierefolien ohne die selbstheilende Schicht sind insbesondere in WO 2011/086272, in WO 2010/133427 oder in der deutschen Patentanmeldung mit der Anmeldenummer 102010038288.4 beschrieben. Erfindungsgemäß hat eine solche Barrierefolie dieser Ausführungsform von der der Sonne zugewandten Seite aus bevorzugt folgenden Aufbau:
eine PFEVE basierende Schicht,
eine erste Trägerschicht, die zu mehr als 50 Gew% aus PMMA oder einer PMMA-haltigen Polymermischung besteht und eine Dicke zwischen 50 und 400 µm aufweist,
eine Kleberschicht, bevorzugt eine Ethylen-Acrylat-Hotmeltschicht, mit einer Dicke zwischen 20 und 80 µm,
eine zweite Trägerschicht aus Polyester oder einem Polyolefin mit einer Dicke zwischen 100 und 400 µm und
eine SiOₓ-Schicht mit einer Dicke zwischen 10 und 100 nm.

Dabei können eine oder mehrere dieser Schichten in einem Laminat auch mehrfach vorliegen. Darüber hinaus können auch zusätzliche Schichten vorliegen.

In der dritten bevorzugten Ausführungsform handelt es sich bei dem Verbundformkörper um spezielle Linsen für Sölarthermie- oder CPV-Photovoltaikanlagen. Solche Linsen ohne eine selbstheilende Schicht sind beispielsweise in der deutschen Patentanmeldung mit der Anmeldenummer 102011003311.4 beschrieben.

Die Konzentration der solaren Strahlung in dieser Ausführungsform kann dabei auf die 2-dimensionale Geometrie einer Photovoltaikzelle, sowie auf einen Stirling-Motor oder einen 2-dimensionalen thermischen Receiver einer Solarthermieanlage erfolgen.

Neben diesen beschriebenen Ausführungsformen der Verbundformkörper umfasst die vorliegende Erfindung auch die Verwendung eines erfindungsgemäßen Verbundformkörpers in Anlagen zur solaren Energiegewinnung im Allgemeinen. Insbesondere umfasst die vorliegende Erfindung die Verwendung der erfindungsgemäßen Verbundformkörper zur Konzentration solarer Strahlung in Solarreflektoren, als Barrierefolie in flexiblen Photovoltaikzellen oder als CPV-Linsen in Solarthermie- oder Photovoltaikanlagen.

Für alle Ausführungsformen können sowohl plane Platten, als auch bevorzugte gebogene Formen hergestellt und in die Anlagen zur solaren Energiegewinnung eingebaut werden. Die Einformung kann nach der Herstellung der Konzentratoren und dem anschließenden Zuschneiden zum Beispiel unter Kalteinbiegung oder Warmformung, wobei ein Kaltbiegenverfahren bevorzugt ist, durchgeführt werden.

### Beispiele

### Vorstufe 1

Eine 0,15 mm dicke Verbundfolie, bestehend aus 0,125 mm PMMA Plexiglas 7H, welches zwecks UV-Additivierung 2 % CGX 006 sowie 0,6 % Chimasorb 119 enthält, sowie 0,025 mm Polycarbonat Makrolon 2607, wird mittels Adapter-Coextrusion hergestellt.
Darauf erfolgt die Applikation der reflektierenden Beschichtung mittel eines plasmagestützten Sputterprozess auf die Polycarbonat-Seite der Verbundfolie, bestehend aus, von der Polycarbonatfolie aus betrachtet in folgender Reihenfolge, 0,5 nm ZAO (Zink-Aluminiumoxid), 100 nm Ag sowie 50 nm Cu.

### Vergleichsbeispiel.

Es werden 25 Gew% Reaktivverdünner 1,6-Hexandioldiacrylat vorgelegt und nach einander unter Rühren mit 0,1 Gew% Byk UV 3510 (Verlaufsadditiv), 2,5 Gew% Irgacure 184 (Photoinitiator), 2,0 Gew% Tinuvin 400 (UV-Absorber) und 0,4 Gew% Tinuvin 123 (HALS-Verbindung) gemischt. Anschließend werden 70 Gew% eines Urethanacrylats Ebecryl 1290 bei einer Rührgeschwindigkeit von 600 U/min so lange eingemischt, bis eine klare und homogene Mischung entstanden ist.
Der Lack wird mittels 12 µm Spiralrakel unter Normalklima auf die PMMA-Seite des Substrats aus Vorstufe 1 appliziert. Die Härtung bzw. Trocknung erfolgt unter Stickstoff-Atmosphäre und einem Sauerstoffgehalt unter 500 ppm mittels eines Fe-dotierten Quecksilberstrahlers mit 135 W/cm und einer Bandgeschwindigkeit von 3 m/min.

### Beispiel

28,9 Gew% Lumiflon LF-9716 (PFEVE) werden in einem Lösungsmittelgemisch aus 12,4 Gew% Ethyl-ethoxy-propionat und 37,3 Gew% Butylacetat vorgelegt und nach einander unter Rühren mit 0,0013 Gew% DBTDL (Dibutylzinndilaureat; Vernetzungskatalysator), 3,4 Gew% Tinuvin 400 (UV-Absorber) und 1,1 Gew% Tinuvin 123 (HALS-Verbindung) bis eine homogene, klare Mischung entstanden ist, gemischt. Anschließend werden 16,9 Gew% Desmodur N 3300 (Polyisocyanat, Vernetzer) für 10 min eingerührt.
Der Lack wird mittels 40 µm Spiralrakel unter Normalklima auf die PMMA-Seite des Substrats aus Vorstufe 1 appliziert. Die Trocknung und Vorhärtung erfolgen 2 Stunden bei 80 °C im Umluftofen. Bereits nach 10 min ist die Beschichtung tack-free. Die Nachhärtung erfolgt entweder über 7 Tage bei Raumtemperatur oder für 2 Stunden bei 80 °C.

### Prüfungsergebnisse

1. Prüfung des selbstheilenden Charakters:
   a.) Proben werden dem Sandrieseltest gemäß DIN 52348 (3 kg Sand) unterzogen.
   b.) Anschließend wird die TSR-Direkt (25 mrad Öffnungswinkel) gemäß ASTM G 159 gemessen.
   c.) Danach erfolgt die Temperung für 2 Tage bei 55 °C (typischer Betriebstemperaturbereich polymerer Solarspiegel im Wüstenklima) sowie eine zweite TSR-Direkt Messung.

Ergebnis: Das Vergleichsbeispiel zeigt keine Erholung der Abrasionsschädigung, währenddessen die erfindungsgemäß hergestellte Probe 68 % Erholung der Schädigung zeigt.

### 2. Ritzenhärteuntersuchung mit 1 - 3 N Ritzkraft

Durchführung: Die Proben werden vor der Prüfung oberflächlich gereinigt. Die Prüfung erfolgt mit einem ZHT 2092 Zehntner-Härteprüfstift mit einer Prüfspitze 0,75 mm der Firma Bosch, einem ACC 112 Handwagen und verschiedenen Druckfedern. Dabei wird mit verschiedenen definierten Druckfedern bei unterschiedlichen Kräften die Prüfspitze über den Probenkörper gradlinig gezogen. Durch Vorspannen der Druckfeder wird die Federkraft eingestellt, der Härteprüfstift mit der Spitze auf die Oberfläche aufgesetzt und das Prüfgerät gegen den Federdruck senkrecht auf die Oberfläche angedrückt. Der Handwagen wird dann geradlinig und mit einer Geschwindigkeit von ca. 10 mm/s vom Körper weg über den Probekörper gezogen. Diese Handhabung sollte mit geänderter Federkraft sooft wiederholt werden bis eine leichte Verletzung der Prüfoberfläche sichtbar wird. Nach den Prüfzyklen ist die Druckfeder zu entspannen.
Die Stellung des Schiebers zeigt an einer Skala die Kraft (N) und damit direkt den der Härte entsprechenden Prüfwert an. Die niedrigste Kraft, welche einen sichtbaren Ritz in das Material eingebracht hat, wird als Ergebnis verwendet. Optional kann mit dem taktilen Messgerät die Ritztiefe ermittelt werden.

Ergebnis: Gemäß dieser Methode applizierte Ritze - zur Nachstellung einer Bürstenreinigungsbeanspruchung stellen sich nach einer Temperung für 2 Tage bei 55 °C bei der erfindungsgemäßen Probe zu 100 % zurück. Die Vergleichsprobe zeigt keinerlei Rückstellung hierbei.

## Patentansprüche

1. Verbundformkörper zur Anwendung in Solaranlagen der solaren Energiegewinnung **dadurch gekennzeichnet, dass** der Verbundformkörper eine äußere Schicht mit selbstheilenden Eigenschaften aufweist, wobei die äußere Schicht auf einem vernetzbaren Fluorpolymer basiert und optionale Zuschlagsstoffe enthält, **dadurch gekennzeichnet**, das der Verbundformkörper eine äußere Schicht basierend auf PFEVE aufweist.

2. Verbundformkörper gemäß Anspruch 1, **dadurch gekennzeichnet, dass** die äußere Schicht eine Glastemperatur zwischen 10 und 70 °C aufweist und vernetzt ist.

3. Verbundformkörper gemäß mindestens einem der Ansprüche 1 bis 2,
**dadurch gekennzeichnet, dass** die äußere Schicht eine Dicke zwischen 0,5 µm und 200 µm aufweist.

4. Verbundformkörper gemäß mindestens einem der Ansprüche 1 bis 3,
**dadurch gekennzeichnet, dass** es sich bei dem Verbundformkörper um einen Solarreflektor für Solarthermieanlagen handelt.

5. Verbundformkörper gemäß Anspruch 4, **dadurch gekennzeichnet, dass** der Verbundformkörper von der der Sonne zugewandten Seite aus mindestens folgende Schichten aufweist:
eine selbstheilende Schicht,
eine erste Trägerschicht,
eine optionale zweite Trägerschicht,
eine reflektierende Beschichtung aus Silber, einer Silberlegierung oder
Aluminium auf der Rückseite der zweiten Trägerschicht und
optionale weitere mittels PVD oder CVD aufgetragene Beschichtungen oder eine weitere Kratzfestbeschichtung.

6. Verbundformkörper gemäß Anspruch 5, **dadurch gekennzeichnet, dass** der Verbundformkörper von der der Sonne zugewandten Seite aus mindestens folgende Schichten aufweist:
eine PFEVE-basierende Schicht,
eine erste Trägerschicht, die zu mehr als 50 Gew% aus PMMA oder einer PMMA-haltigen Polymermischung besteht, und eine Dicke zwischen 6 µm und 10 cm aufweist,
eine zweite Trägerschicht aus Polycarbonat oder einem Polyester, die eine Dicke zwischen 0,5 µm und 2 cm aufweist,
eine reflektierende Beschichtung aus Silber, einer Silberlegierung oder
Aluminium auf der Rückseite der zweiten Trägerschicht, welche mittels PVD oder CVD aufgetragen wurde und
optionale weitere mittels PVD oder CVD aufgetragene Beschichtungen oder eine duroplastische Polysilazan-Schicht.

7. Verbundformkörper gemäß mindestens einem der Ansprüche 1 bis 3,
**dadurch gekennzeichnet, dass** es sich bei dem Verbundformkörper um eine Barrierefolie für Photovoltaikanlagen handelt.

8. Verbundformkörper gemäß Anspruch 7, **dadurch gekennzeichnet, dass** der Verbundformkörper von der der Sonne zugewandten Seite aus mindestens folgende Schichten aufweist:
eine PFEVE-basierende Schicht,
eine erste Trägerschicht, die zu mehr als 50 Gew% aus PMMA oder einer PMMA-haltigen Polymermischung besteht und eine Dicke zwischen 50 und 400 µm aufweist,
eine Kleberschicht, bevorzugt eine Ethylen-Acrylat-Hotmeltschicht, mit einer Dicke zwischen 20 und 80 µm,
eine zweite Trägerschicht aus Polyester oder einem Polyolefin mit einer Dicke zwischen 100 und 400 µm und
eine SiOₓ-Schicht mit einer Dicke zwischen 10 und 100 nm.

9. Verbundformkörper gemäß mindestens einem der Ansprüche 1 bis 3,
**dadurch gekennzeichnet, dass** es sich bei dem Verbundformkörper um Linsen für Solarthermie- oder CPV-Photovoltaikanlagen handelt.

10. Verbundformkörper gemäß mindestens einem der Ansprüche 1 bis 9,
**dadurch gekennzeichnet, dass** die PFEVE-basierende Schicht zusätzlich mit einer weiteren Kratzfestbeschichtung, leitfähigen Schicht, Antisoiling-Beschichtung und/oder reflektionserhöhenden Schichten oder anderen optisch funktionelle Schichten versehen ist.

11. Verfahren zur Herstellung eines Verbundformkörpers für Solaranlagen gemäß mindestens einem der Ansprüche 1 bis 10, **dadurch gekennzeichnet, dass** ein Verbundkörper, mindestens eine Schicht aufweisend, die zu mehr als 50 Gew% aus PMMA oder einer PMMA-haltigen Polymermischung besteht, mit einer PFEVE-basierenden Formulierung in einer Dicke zwischen 0,5 µm und 200 µm beschichtet wird.

12. Verfahren gemäß Anspruch 11, **dadurch gekennzeichnet, dass** die PFEVE-basierende Formulierung in Form einer organischen Lösung auf den Verbundformkörper aufgetragen und anschließend getrocknet wird.

13. Verfahren gemäß Anspruch 12, **dadurch gekennzeichnet, dass** die Beschichtung in-line, direkt nach der Herstellung des Verbundformkörpers, erfolgt.

14. Verfahren gemäß Anspruch 13, **dadurch gekennzeichnet, dass** die PFEVE-basierende Schicht anschließend mit einer weiteren funktionellen Schicht versehen wird.

15. Verwendung eines Verbundformkörpers gemäß einem der Ansprüche 1 bis 10 zur Konzentration solarer Strahlung in Solarreflektoren, als Barrierefolie in flexiblen Photovoltaikzellen oder als CPV-Linsen in Solarthermie- oder Photovoltaikanlagen.

## Claims

1. Composite moulding for use in solar systems of solar energy generation, **characterized in that** the composite moulding has an outer layer having self-healing properties, wherein the outer layer is based on a crosslinkable fluoropolymer and comprises optional adjuvants, **characterized in that** the composite moulding has an outer layer based on PFEVE.

2. Composite moulding according to Claim 1, **characterized in that** the outer layer has a glass transition temperature of between 10 and 70°C and is crosslinked.

3. Composite moulding according to at least one of Claims 1 to 2, **characterized in that** the outer layer has a thickness of between 0.5 µm and 200 µm.

4. Composite moulding according to at least one of Claims 1 to 3, **characterized in that** the composite moulding is a solar reflector for solar thermal collector systems.

5. Composite moulding according to Claim 4, **characterized in that** the composite moulding, from the sun-facing side, has at least the following layers:
a self-healing layer,
a first support layer,
an optional second support layer,
a reflective coating of silver, of a silver alloy or aluminium on the rear of the second support layer, and
optional further PVD- or CVD-applied coatings or
a further scratch-resistant coating.

6. Composite moulding according to Claim 5, **characterized in that** the composite moulding, from the sun-facing side, has at least the following layers:
a PFEVE-based layer,
a first support layer which consists to an extent of more than 50% by weight of PMMA or a PMMA-containing polymer mixture and has a thickness of between 6 µm and 10 cm,
a second support layer of polycarbonate or of polyester, which has a thickness of between 0.5 µm and 2 cm,
a reflective coating of silver, of a silver alloy or aluminium on the rear of the second support layer, which has been applied by PVD or CVD, and optional further PVD- or CVD-applied coatings or a thermoset polysilazane layer.

7. Composite moulding according to at least one of Claims 1 to 3, **characterized in that** the composite moulding is a barrier film for photovoltaic systems.

8. Composite moulding according to Claim 7, **characterized in that** the composite moulding, from the sun-facing side, has at least the following layers:
a PFEVE-based layer,
a first carrier layer which consists to an extent of more than 50% by weight of PMMA or a PMMA-containing polymer mixture and has a thickness of between 50 and 400 µm,
a layer of adhesive, preferably an ethylene-acrylate hotmelt layer, having a thickness of between 20 and 80 µm,
a second support layer of polyester or a polyolefin, having a thickness of between 100 and 400 µm, and
an SiOₓ layer having a thickness of between 10 and 100 nm.

9. Composite moulding according to at least one of Claims 1 to 3, **characterized in that** the composite moulding comprises lenses for solar thermal collector systems or CPV photovoltaic systems.

10. Composite moulding according to at least one of Claims 1 to 9, **characterized in that** the PFEVE-based layer is additionally provided with a further scratch-resistant coating, conductive layer, anti-soiling coating and/or reflection-increasing layers or other optically functional layers.

11. Process for producing a composite moulding for solar systems according to at least one of the Claims 1 to 10, **characterized in that** a composite moulding having at least one layer which consists to an extent of more than 50% by weight of PMMA or of a PMMA-containing polymer mixture is coated with a PFEVE-based formulation in a thickness of between 0.5 µm and 200 µm.

12. Process according to Claim 11, **characterized in that** the PFEVE-based formulation is applied in the form of an organic solution to the composite moulding and is subsequently dried.

13. Process according to Claim 12, **characterized in that** the coating takes place in-line directly after the production of the composite moulding.

14. Process according to Claim 13, **characterized in that** the PFEVE-based layer is subsequently provided with a further functional layer.

15. Use of a composite moulding according to any of Claims 1 to 10 for concentrating solar radiation in solar reflectors, as barrier film in flexible photovoltaic cells or as CPV lenses in solar thermal collector systems or photovoltaic systems.

## Revendications

1. Corps moulé composite destiné à une utilisation dans des installations solaires de production d'énergie solaire, **caractérisé en ce que** le corps moulé composite comprend une couche extérieure à propriétés autorégénératrices, la couche extérieure étant à base d'un fluoropolymère réticulable et contenant éventuellement des additifs, **caractérisé en ce que** le corps moulé composite comprend une couche extérieure à base de PFEVE.

2. Corps moulé composite selon la revendication 1, **caractérisé en ce que** la couche extérieure présente une température de transition vitreuse comprise entre 10 et 70 °C et est réticulée.

3. Corps moulé composite selon au moins l'une quelconque des revendications 1 à 2, **caractérisé en ce que** la couche extérieure présente une épaisseur comprise entre 0,5 µm et 200 µm.

4. Corps moulé composite selon au moins l'une quelconque des revendications 1 à 3, **caractérisé en ce que** le corps moulé composite consiste en un réflecteur solaire pour des installations héliothermiques.

5. Corps moulé composite selon la revendication 4, **caractérisé en ce que** le corps moulé composite comprend au moins les couches suivantes sur le côté orienté vers le soleil :
une couche autorégénératrice,
une première couche support,
éventuellement une seconde couche support,
un revêtement réfléchissant en argent, en un alliage d'argent ou en aluminium sur le côté arrière de la seconde couche support, et
éventuellement d'autres revêtements appliqués par PVD ou CVD ou un revêtement supplémentaire résistant aux éraflures.

6. Corps moulé composite selon la revendication 5, **caractérisé en ce que** le corps moulé composite comprend au moins les couches suivantes sur le côté orienté vers le soleil :
une couche à base de PFEVE,
une première couche support, qui est constituée à plus de 50 % en poids de PMMA ou d'un mélange de polymères contenant du PMMA, et qui présente une épaisseur comprise entre 6 µm et 10 cm,
une seconde couche support en polycarbonate ou en un polyester, qui présente une épaisseur comprise entre 0,5 µm et 2 cm,
un revêtement réfléchissant en argent, en un alliage d'argent ou en aluminium sur le côté arrière de la seconde couche support, qui a été appliqué par PVD ou CVD, et
éventuellement d'autres revêtements appliqués par PVD ou CVD ou une couche de polysilazane duroplastique.

7. Corps moulé composite selon au moins l'une quelconque des revendications 1 à 3, **caractérisé en ce que** le corps moulé composite consiste en une feuille de barrière pour des installations photovoltaïques.

8. Corps moulé composite selon la revendication 7, **caractérisé en ce que** le corps moulé composite comprend au moins les couches suivantes sur le côté orienté vers le soleil :
une couche à base de PFEVE,
une première couche support, qui est constituée à plus de 50 % en poids de PMMA ou d'un mélange de polymères contenant du PMMA, et qui présente une épaisseur comprise entre 50 et 400 µm,
une couche adhésive, de préférence une couche thermofusible en éthylène-acrylate, d'une épaisseur comprise entre 20 et 80 µm,
une seconde couche support en polyester ou en une polyoléfine, d'une épaisseur comprise entre 100 et 400 µm, et
une couche de SiOₓ d'une épaisseur comprise entre 10 et 100 nm.

9. Corps moulé composite selon au moins l'une quelconque des revendications 1 à 3, **caractérisé en ce que** le corps moulé composite consiste en des lentilles pour des installations héliothermiques ou photovoltaïques CPV.

10. Corps moulé composite selon au moins l'une quelconque des revendications 1 à 9, **caractérisé en ce que** la couche à base de PFEVE est en outre munie d'un revêtement supplémentaire résistant aux éraflures, d'une couche conductrice, d'un revêtement antitache et/ou de couches augmentant la réflexion ou d'autres couches fonctionnelles optiques.

11. Procédé de fabrication d'un corps moulé composite pour des installations solaires selon au moins l'une quelconque des revendications 1 à 10, **caractérisé en ce qu'**un corps composite comprenant au moins une couche qui est constituée à plus de 50 % en poids de PMMA ou d'un mélange de polymères contenant du PMMA est revêtu avec une formulation à base de PFEVE en une épaisseur comprise entre 0,5 µm et 200 µm.

12. Procédé selon la revendication 11, **caractérisé en ce que** la formulation à base de PFEVE est appliquée sous la forme d'une solution organique sur le corps moulé composite, puis séchée.

13. Procédé selon la revendication 12, **caractérisé en ce que** le revêtement a lieu en ligne, directement après la fabrication du corps moulé composite.

14. Procédé selon la revendication 13, **caractérisé en ce que** la couche à base de PFEVE est ensuite munie d'une couche fonctionnelle supplémentaire.

15. Utilisation d'un corps moulé composite selon l'une quelconque des revendications 1 à 10 pour la concentration du rayonnement solaire dans des réflecteurs solaires, en tant que feuille de barrière dans des cellules photovoltaïques flexibles ou en tant que lentilles CPV dans des installations héliothermiques ou photovoltaïques.
